(19) Europäisches Patentamt
European Patent Office
Office européen des brevets

(11) EP 4 465 062 A1

(12) **EUROPEAN PATENT APPLICATION**
published in accordance with Art. 153(4) EPC

(43) Date of publication:
**20.11.2024 Bulletin 2024/47**

(21) Application number: **23903667.6**

(22) Date of filing: **22.08.2023**

(51) International Patent Classification (IPC):
***G01R 31/392*** *(2019.01)* ***G01R 31/367*** *(2019.01)*
***G01R 31/3828*** *(2019.01)* ***G01R 19/165*** *(2006.01)*
***H01M 10/48*** *(2006.01)*

(52) Cooperative Patent Classification (CPC):
**G01R 19/165; G01R 31/367; G01R 31/3828; G01R 31/392; H01M 10/48;** Y02E 60/10

(86) International application number:
**PCT/KR2023/012366**

(87) International publication number:
**WO 2024/128463 (20.06.2024 Gazette 2024/25)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **15.12.2022 KR 20220175914**

(71) Applicant: **LG Energy Solution, Ltd.**
**Seoul 07335 (KR)**

(72) Inventor: **LEE, Tae Ho**
**Daejeon 34122 (KR)**

(74) Representative: **Goddar, Heinz J.**
**Boehmert & Boehmert**
**Anwaltspartnerschaft mbB**
**Pettenkoferstrasse 22**
**80336 München (DE)**

(54) **APPARATUS AND METHOD FOR TESTING BATTERY BY ESTIMATING DEGRADATION**

(57) A method for testing a battery rack including at least one battery pack by estimating state of health may include implementing a degraded battery simulation state using a relationship among internal resistance of the battery, current flowing through the battery, and amount of heat generated and performing a degradation prediction test in the degraded battery simulation state.

[Figure 5]

battery verification time shortened by 6 months or more
Phase 3 (6 months)
1) check rack based temperature increase and calculate pack based resistance increase rate based on cell test results
2) conduct rack based performance test using BOL pack
Phase 1(6 months)
1) identify actually measured degradation inflection point of cell, 2) determine cell-based resistance increase rate
=> estimate state of health at 20 years of use through 1) and 2)



Processed by Luminess, 75001 PARIS (FR)

## Description

[Cross-Reference to Related Applciations]

This application claims priority to and the benefit of Korean Patent Application No.10-2022-0175914 filed in the Korean Intellectual Property Office on December 15, 2022, the entire contents of which are incorporated herein by reference.

[Technical Field]

The present invention relates to an apparatus and method for testing batteries by estimating state of health, and more particularly, to an apparatus and method for an apparatus and method for testing batteries by estimating state of health that predicts degradation of a rack including a plurality of battery packs and uses it to verify the battery during battery development.

[Background Art]

Secondary batteries, capable of recharging and reuse, are used as energy sources in small, high-tech electronic devices like smart phones, tablet personal computer, vacuum cleaner as well as a variety of fields including vehicles, and energy storage systems (ESS) for the smart grid.

A battery module or pack, including multiple battery cells, faces safety and operational efficiency issues if certain cells encounter overvoltage, overcurrent, or overheating, necessitating the need for detection mechanisms. Moreover, to avert accidents arising from battery defects and ensure safety throughout the battery lifecycle, it is essential to prepare a comprehensive verification plan encompassing all phases of battery lifecycle.

However, the battery capacity does not persist at its initial capacity in the Beginning Of Life (BOL) state and diminishes over time. The degree of degradation in a secondary battery can be assessed by measuring its capacity and computing the variance between the measured capacity and the BOL capacity. The capacity of the secondary battery can be determined by charging the battery from a complete discharge state until the state of charge (SOC) reaches 100%, with the calculation involving the accumulation of the charging current flowing into the secondary battery throughout the process.

However, recent batteries are expected to come with long-term lifespan warranties, often spanning 10 to 20 years. Consequently, conducting actual measurement tests for the entire degradation period before product launch becomes challenging. As a solution, various accelerated verification methods are being proposed.

One of them is a method of predicting lifespan by finding the actual degradation inflection line at a certain cycle level and deriving a lifespan prediction curve for all sections based on it. However, this method has the problem that it takes quite a lot of time to conduct actual measurements and determine the inflection point of degradation. As another option, a method is being used to accelerate battery degradation under harsh conditions and predict state of health based on the acceleration factor. However, even in this method, numerous elements necessitate alignment in terms of the reliability of the acceleration factor, rendering it inconvenient to use and introducing the possibility of reduced prediction accuracy.

[Summary]

[Technical Problem]

To obviate one or more problems of the related art, embodiments of the present disclosure provide an apparatus for testing a battery rack including at least one battery pack by estimating state of health.

To obviate one or more problems of the related art, embodiments of the present disclosure also provide a method for testing a battery rack including at least one battery pack by estimating state of health.

[Technical Solution]

In order to achieve the objective of the present disclosure, an apparatus for testing battery by estimating state of health may be an apparatus for testing a rack including at least one battery pack and include at least one processor; and a memory configured to store instructions executed by the at least one processor, and the instructions, when executed, may cause the processor to implement a degraded battery simulation state using a relationship among an internal resistance of the battery, a current flowing through the battery, and an amount of heat generated in a degraded batery pack and perform a degradation prediction test in the degraded battery simulation state.

The instructions, when executed, may cause the processor to identify a measured cell degradation inflection point; determine a cell-based resistance increase rate; and calculate a value of current to flow in a batery having a degraded state using the relationship among the internal resistance of the battery, the current flowing through the battery, and the amount of heat generated in the degraded batery pack.

The instructions, when executed, may cause the processor to calculate a battery pack-based resistance increase rate according to the cell-based resistance increase rate; calculate an internal resistance value of the degraded battery pack according to the battery pack-based resistance increase rate; and calculate the value of current to flow in the batery having the degraded state based on the amount of heat generated in the degraded batery pack, an internal resistance value of a non-degraded new battery pack, and the internal resistance value of the degraded battery pack.

Here, the amount of heat generated in the degraded batery pack may be represented in the degraded battery simulation state based on the measured cell degradation inflection point.

Meanwhile, the instructions, when executed, may cause the processor to perform a rack-based temperature test on new battery packs that have not degraded, using the value of current to flow in the battery having the degraded state.

The instructions, when executed, may cause the processor to apply the value of current to flow in the battery having the degraded state to the battery rack using a load connected to the battery rack including at least one non-degraded new battery pack.

According to another embodiment of the present disclosure, a method for testing a battery rack including at least one battery pack by estimating state of health may include implementing a degraded battery simulation state using a relationship among an internal resistance of the battery, a current flowing through the battery, and an amount of heat generated in a degraded batery packand performing a degradation prediction test in the degraded battery simulation state.

Implementing a degraded battery simulation state may include identifying a measured cell degradation inflection point; determining a cell-based resistance increase rate; and calculating a current value flowing in a batery having a degraded state using a relationship among the internal resistance of the battery, the current flowing through the battery, and the amount of heat generated in the degraded batery pack.

The method may include calculating a battery pack-based resistance increase rate according to the cell-based resistance increase rate; and calculating an internal resistance value of the degraded battery pack according to the battery pack-based resistance increase rate, calculating the value of current to flow in the batery having the degraded state may be based on the amount of heat generated in the degraded batery pack, an internal resistance value of a non-degraded new battery pack, and the internal resistance value of the degraded battery pack.

The amount of heat generated in the degraded batery pack represented in the degraded battery simulation state may be based on the measured cell degradation inflection point.

Performing the degradation prediction test may include performing a rack-based temperature test on new battery packs that have not degraded, using the value of current to flow in the battery having the degraded state.

Performing the rack based temperature test may include applying the value of current to flow in the battery having the degraded state to the battery rack using a load connected to the battery rack including at least one non-degraded new battery pack.

[Advantageous Effects]

According to the above-described embodiment of the present invention, battery verification can be conducted through degradation simulation under conditions where battery resistance is not degraded during battery development while utilizing other factors, so that faster battery verification can be expected compared to existing verification techniques.

[Brief Description of the Drawings]

FIG. 1 shows a structure of a battery system to which the present invention may be applied.

FIG. 2 is a curve showing capacity degradation characteristic of battery.

FIG. 3a shows a voltage curve that varies according to a charge cycle and FIG. 3b shows a voltage curve that varies according to a discharge cycle.

FIG. 4 is a diagram schematically showing a general degradation prediction technique using the actually measured degeneration inflection curve.

FIG. 5 is a diagram schematically showing a concept of a test method for predicting battery degradation according to embodiments of the present invention.

FIG. 6 shows a battery degradation prediction test environment according to embodiments of the present invention.

FIG. 7 is a block diagram of an apparatus for testing a battery by estimating state of health according to embodiments of the present invention.

FIG. 8 shows an operational sequence of a method for testing a battery by estimating state of health according to embodiments of the present invention.

100: battery rack
200: load
300: apparatus for testing battery by estimating state of health

[Detailed Description]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

Hereinafter, exemplary embodiments of the present invention will be described in detail with reference to the accompanying drawings.

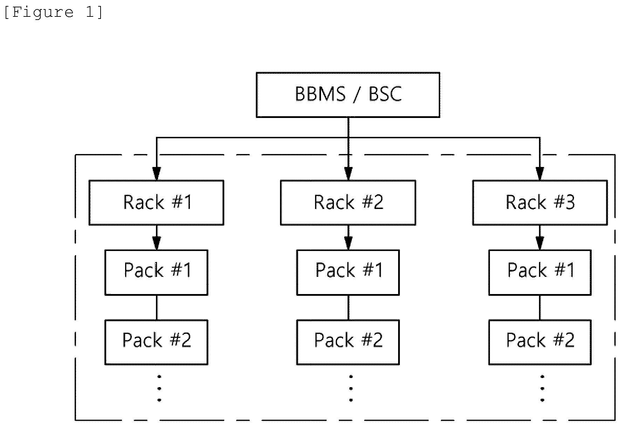

FIG. 1 shows a structure of a battery system to which the present invention may be applied.

In the battery system of FIG. 1, multiple battery packs may be included in a battery rack and multiple battery racks may be included in a battery bank.

Here, a battery management system (BMS) may be installed in each of the battery packs, battery racks, and battery banks. In FIG. 1, the battery pack may include a plurality of battery cells connected in series. The battery pack may be connected to a load through positive and negative terminals and perform charging/discharging operations. The most commonly used battery cells are lithium-ion (Li-Ion) battery cells. A battery management system (BMS) may be installed for each of the battery packs.

A Pack BMS may monitor current, voltage, and temperature of each battery pack to be managed, calculate SOC (State of Charge; charge rate) based on the monitoring results, and control charging and discharging. Here, the SOC refers to a current charged state of a battery, represented in percent points [%].

To perform such operations, the BMS may include various components such as fuses, current sensing elements, thermistors, switches, and balancers, and further include an MCU (Micro Controller Unit) or BMIC (Battery Monitoring Integrated Chip) to interface with and control these components in most cases. Here, the BMIC may be located inside the BMS and may be an IC-type component that measures information such as voltage, temperature, and current of the battery cell/pack.

In addition, each rack BMS (RBMS) may manage each battery rack, and the Bank BMS (BBMS) may control the battery bank including these battery racks in overall. Each RBMS may monitor the current, the voltage, and the temperature of each battery rack, calculate a SOC based on the monitoring results, and control charging and discharging.

Meanwhile, a battery section controller (BSC) may be installed in each battery section, which includes multiple batteries and peripheral circuits, devices, etc., to monitor and control objects such as voltage, current, temperature, and circuit breakers. In the embodiment of FIG. 1, the bank BMS (BBMS) is shown as performing the same function as the BSC, and may be referred to as BBMS or BSC depending on the system.

In addition, the BMS may monitor battery cells, read cell voltages, and transmit them to other systems connected to the battery. For this, the BMS may include a communication module for communicating with other systems in a device including the battery system. The communication module of the BMS may communicate with other systems using the Controller Area Network (CAN). Here, components, modules or systems in the BMS are connected to one onother through a CAN bus.

Meanwhile, capacity of the battery decreases as the calendar time or cycle time elapses without maintaining its capacity in the beginning of life (BOL) state. Here, the calendar time refers to a cumulative time that the secondary battery maintains an unloaded state, and the cycle time refers to a cumulative time that the secondary battery maintains charging or discharging. The decrease in battery capacity may be quantitatively calculated by the degree of degradation (or aging). The state of health (or degree of degradation) may be defined by a ratio of the capacity in the current state to the capacity in the BOL state, and is a measure of a replacement cycle of the secondary battery.

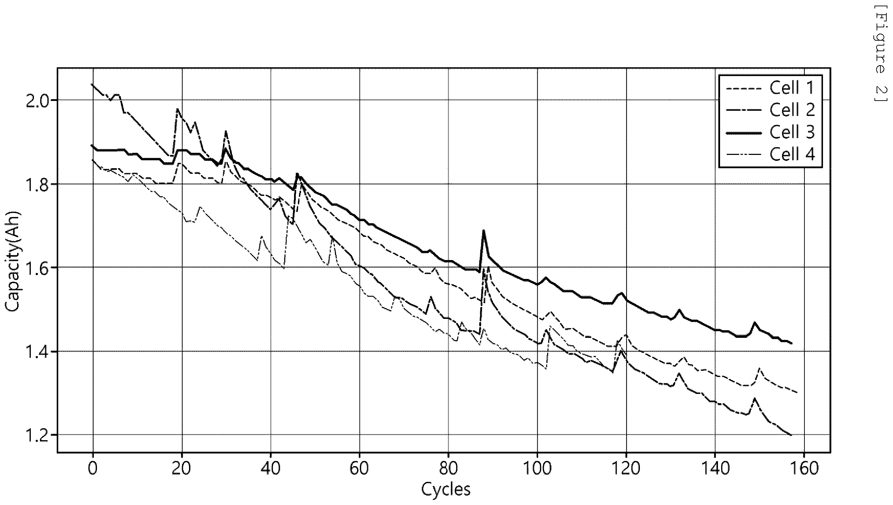

FIG. 2 is a curve showing capacity degradation characteristic of battery.

FIG. 2 shows that capacities of aged batteries are degrading as the number of cycles increases. Referring to FIG. 2, the initial capacities of battery cells 1, 2, 3, and 4 are different, but they have the same characteristic that the capacity decreases as the cycle is repeated in overall. However, the capacity of the battery cell does not decrease uniformly, but there is a section where the capacity increases. If the battery is continuously used, resistance increases and cell voltage decreases, whereas the chemical reaction inside the battery during sleep time stabilizes. This leads to output voltage increase and causes battery capacity retention. Thus, the retention capacity of a battery is affected by a length of a sleep period, a cell temperature during the sleep period, etc. Meanwhile, looking at the capacity degradation curve from a larger trend, there is an inflection point and the curve becomes gradual after the inflection point.

Meanwhile, the battery degradation parameters include resistance in addition to capacity.

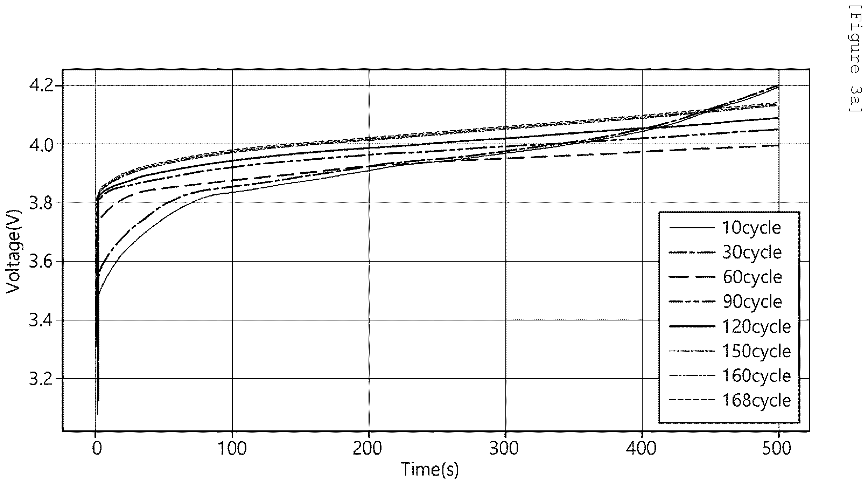

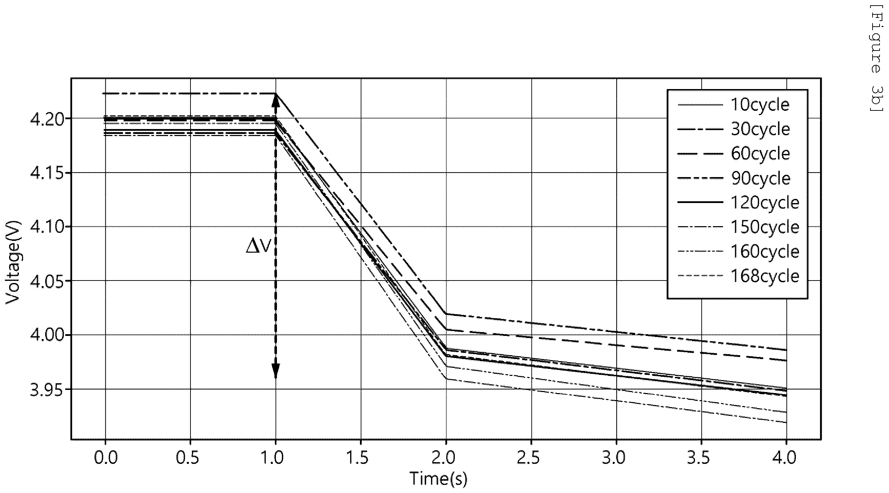

FIG. 3a shows a voltage curve that varies according to a charge cycle and FIG. 3b shows a voltage curve that varies according to a discharge cycle.

FIG. 3a shows a voltage curve that varies as five charge cycles are repeated. FIG. 3b shows a voltage curve that varies as five discharge cycles are repeated.

Referring to FIG. 3a, it shows that the time to reach the maximum voltage decreases as the charge cycle increases. In addition, FIG. 3b shows that the amount of voltage change increases as the cycle of the discharge profile increases. Therefore, it can be understood that the internal resistance increases as the battery ages, which means a decrease in battery performance.

From the actually measured cell degradation inflection point as shown in FIG. 2, the degradation state, the state of health (SOH) of the battery, after a certain period of time may be predicted. In addition, the level of heat generation at each time point of degradation (or aging) may be identified from the resistance increase rate as shown in FIGS. 3A and 3B. Thus, the SOH or the quantity of generated heat in a degraded battery per each year may be predicted through the degradation inflection point and the resistance increase rate at each time point.

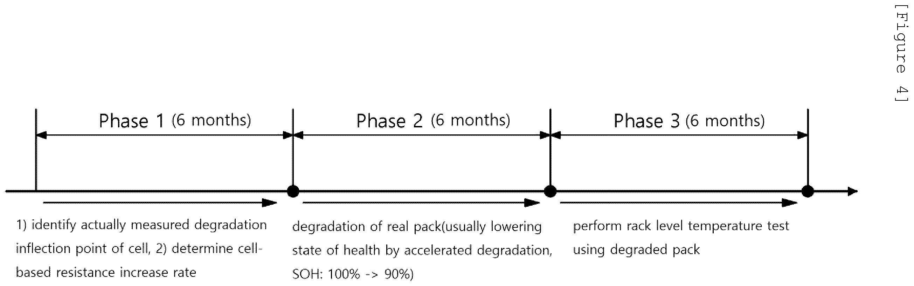

FIG. 4 is a diagram schematically showing a general degradation prediction technique using the actually measured degeneration inflection curve.

Referring to FIG. 4, a typical degradation prediction technique includes a first step (phase 1) of identifying the actually measured degradation inflection point of cell and the cell-based resistance increase rate, a second step (phase 2) of identifying the actually measured degradation inflection point of a real aged pack, and a third step (phase 3) of performing a rack-level temperature test using the aged pack.

In the first step, a test is conducted for each battery cell for preset cycles to check a degradation inflection point and resistance increase rate according to an actually measured degradation curve. Additionally, in the second step, the actual deterioration inflection point of the battery pack including a plurality of battery cells may be determined. Specifically, in the second step of a typical degradation prediction technique, a battery pack including a plurality of battery cells is constructed, and a test is performed for preset cycles to determine the actual degradation curve and resistance increase rate for the battery pack. Here, as the number of cycles required for testing increases and the longer the time, the verification period increases accordingly, so a method of quickly deteriorating the battery through accelerated testing using an acceleration factor may be used. In other words, a process of accelerated degrading actual battery packs is performed, for example, a battery pack with a SOH of 100% may be reduced to about 90% of SOH. Then, in the third step, performance evaluation is performed on a battery rack containing a plurality of degraded battery packs, wherein performance evaluation may be conducting a temperature test based on the degraded rack.

When using typical battery degradation prediction technique as shown in FIG. 4, there is a problem that it takes a considerable amount of time for actual measurement and determination of the degradation inflection point.

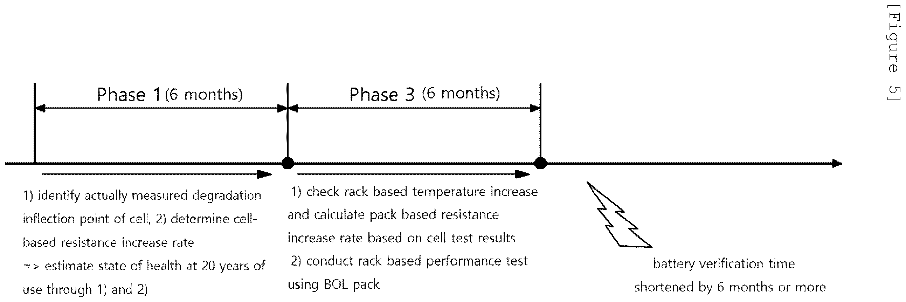

FIG. 5 is a diagram schematically showing a concept of a test method for predicting battery degradation according to embodiments of the present invention.

The present invention may perform more fast verification of battery degradation through a degradation simulation using other factors without degrading a battery resistor.

More specifically, referring to FIG. 5, the battery degradation prediction method according to embodiments of the present invention may include a first step (phase 1) of identifying an actually measured cell degradation inflection point and a cell-based resistance increase rate and a third step (phase 3) of performing a rack based temperature test using a new (BOL) battery pack that has not deteriorated.

In the first step, a test is performed for each battery cell for a preset number of cycles to check the degradation inflection point and the resistance increase rate according to actual degradation curves. In other words, battery degradation characteristic curves as illustrated in FIGS. 2 and 3 may be derived through cell based testing, and trends of the corresponding curves may be used to predict the SOH or quantity of heat generation of degraded state of 20 years after, which is the warranty period. Here, the heat generation amount of the degraded battery may be determined according to an actually measured degradation inflection point of the cell. Looking at the capacity degradation curve in a larger trend, there is an inflection point and change of the curve becomes gradual after the inflection point. Therefore, if the test is carried out to the point where a predicted trend line can be drawn, the remaining capacity of the degraded battery at a point of 20 years of use, which is the warranty period, and the corresponding heat generation amount at that point can be predicted according to the predicted trend line.

After performing the first step, the present invention takes advantage of this point and omits the second step process used in a typical degradation prediction technique, and proceeds directly to the third step, which is a rack based temperature test. In the third step, a temperature test is performed on a battery rack including a plurality of non-degraded BOL battery packs to predict whether the battery rack simulated in a degraded state operates normally. More specifically, in the third step, a temperature increase in a battery pack may be determined by referring to result of confirming the actual degradation inflection point for the cell and the cell-based resistance increase rate and a pack based resistance increase rate may be calculated. In other words, a rack based performance test is conducted using a BOL state pack.

In general, when a battery ages, a level of heat generation during charging and discharging increases due to an increase of internal resistance (Ri), and the amount of heat (Q) generated at this time may be presented as $Q = I^2R_i$ (I = current flowing in the battery). In other words, in the present invention, a rack based temperature test may be performed while simulating degraded battery state by fixing the amount of heat generated and increasing the current flowing in the battery.

According to the present invention, the second step among the steps included in the existing accelerated degradation prediction test method is no longer needed, and the battery verification time can be shortened by approximately 6 months or more.

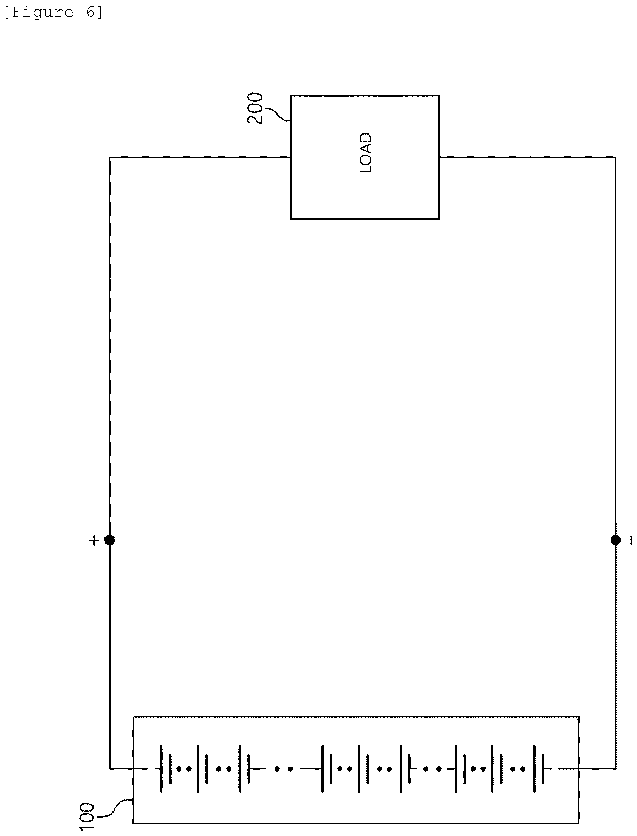

FIG. 6 shows a battery degradation prediction test environment according to embodiments of the present invention.

In the battery degradation prediction method according to the present invention, as shown in the example in FIG. 6, a battery pack or battery rack is connected to a load for testing, current is applied to the battery rack, and a degradation prediction test may be performed.

If the SOH in the initial state of a battery is 100%, the remaining capacity $SOH_{EOL}$ after the battery ages for 20 years (performance guarantee period) may be less than 100%, for example, $SOH_{20y}$ = 60%. Here, $I_{EOL}$ is the current flowing when the battery is in an end of life (EOL) state, and in this embodiment, $I_{EOL}$ is assumed to be a current flowing in a battery that has been degraded for 20 years. In the present invention, the degradation state of a battery that has reached the performance guarantee period is simulated by applying $I_{EOL}$ to a battery pack or rack using a load.

As the internal DCIR resistance increases due to battery degradation, the amount of heat generated also increases accordingly. The amount of heat generated $Q_{BOL}$ of a battery pack in an initial new state and the amount of heat generated $Q_{EOL}$ of a battery pack in a degraded state can be represented in mathematical equations as follows.

【Equation 1】

$$Q_{BOL} = I^2 \times DCIR_{BOL}$$
$$Q_{EOL} = I^2 \times DCIR_{EOL}$$

In Equation 1, $DCIR_{BOL}$ represents internal resistance of a new (BOL; Beginning of Life) battery. $DCIR_{EOL}$ represents internal resistance of end of life (EOL) state battery. Here, SOH may be a value less than 100%, for example, 60%.

In addition, the internal DCIR resistance that increases due to degradation may be expressed as Equation 2 below.

【Equation 2】

$$DCIR_{EOL} = DCIR_{BOL} \times R_{ADD}$$

Here, $R_{ADD}$ is increase rate of the internal resistance of the battery, and as the battery deteriorates, the internal resistance increases. If equation 2 is applied to equation 1, the equation related to quantity of heat generation $Q_{EOL}$ in a degraded state of the battery, the quantity of heat generation $Q_{EOL}$ in the degraded state may be expressed as Equation 3 below.

【Equation 3】

$$\begin{aligned} Q_{EOL} &= I^2 \times DCIR_{BOL} \times R_{ADD} \\ &= (I^2 \times R_{ADD}) \times DCIR_{BOL} \\ &= I^2_{EOL} \times DCIR_{BOL} \end{aligned}$$

In embodiments of the present invention, in order to generate the same amount of heat as that of a degraded pack from a new pack that has not degraded, the DCIR value is kept the same as that of the new pack and the amount of heat is increased by increasing the value of current. In other words, in the embodiment of the present invention, it can be simulated like a degraded pack by setting the DCIR value of the new, non-degraded pack to be fixed and adjusting a value of current to be applied to the battery rack to be tested (to be verified) to $I_{EOL}$ so that the amount of heat generation of the new, non-degraded pack used in the test is the same as that of the degraded pack.

Rearranging the relationships between Equation 1 and Equation 3 based on this understanding, the current $I_{EOL}$ to be applied to the battery rack in the battery degradation simulation test according to the present invention may be expressed as Equation 4 below.

【Equation 4】

$$I_{EOL} = \sqrt{\frac{I^2 \times DCIR_{EOL}}{DCIR_{BOL}}}$$

In other words, according to embodiments of the present invention, the value of current to flow through the battery in a degraded state may be calculated based on the amount of heat generated in a degraded pack, the internal resistance value of a new, non-degraded battery pack, and the internal resistance value of the battery in a degraded state that can be calculated according to the pack based resistance increase rate.

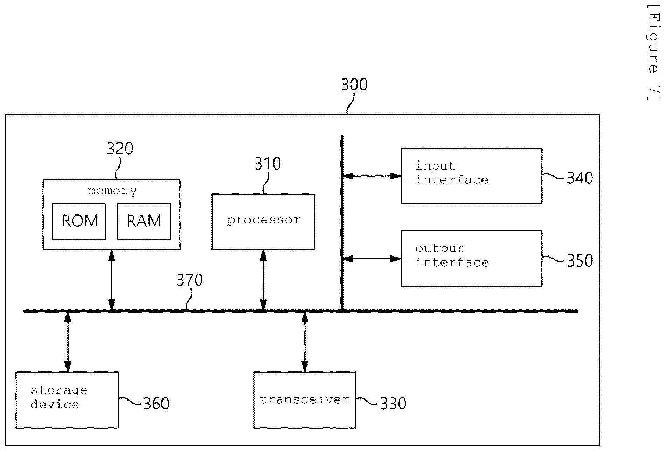

FIG. 7 is a block diagram of an apparatus for testing a battery by estimating state of health according to embodiments of the present invention.

The apparatus for testing a battery by estimating state of health 300 according to the present invention may include at least one processor 310; a memory 320 configured to store at least one instruction executed by the at least one processor. Here, the processor may be, for example, various types of controllers.

The at least one instruction may include an instruction to implement a degraded battery simulation state using a relationship among internal resistance of the battery, current flowing through the battery, and amount of heat generated and an instruction to perform a degradation prediction test in the degraded battery simulation state.

The instruction to implement the degraded battery simulation state may include an instruction to identify actually measured cell degradation inflection point; an instruction to check cell based resistance increase rate; and an instruction to calculate a value of current to flow in a batery of degraded state using a relationship among the internal resistance of the battery, the current flowing through the battery, and the amount of heat generated.

The instruction to calculate the value of current to flow in a batery of degraded state may include an instruction to calculate a battery pack based resistance increase rate according to the cell based resistance increase rate; and an instruction to calculating the value of current to flow in the batery of degraded state based on the amount of heat generated in a degraded batery pack, an internal resistance value of a non-degderaded new battery pack, and an internal resistance value of the degraded battery pack which is calculated according to the battery pack based resistance increase rate.

Here, the amount of heat generated in the degraded batery pack may be calculated based on an amount of heat generation of a cell which is determined according to an actually measured cell degradation inflection point. As described earlier, Looking at the capacity degradation curve from a larger trend, there is an inflection point and the curve becomes gradual after the inflection point. Thus, if the test is carried out to the point where a predicted trend line can be drawn, the remaining capacity of an aged battery at a point of 20 years of use, which is the warranty period, and the corresponding heat generation amount at that point can be predicted according to the predicted trend line.

The instruction to perform the degradation prediction test in the degraded battery simulation state may include an instruction to perform a rack based temperature test on new battery packs that have not degraded, using the value of current to flow in the battery of degraded state.

The instruction to perform the rack based temperature test may include an instruction to apply the current to flow in the battery of degraded state to the battery rack using a load connected to the battery rack including at least one non-degraded new battery pack.

Meanwhile, the apparatus 300 for testing a battery by estimating state of health according to the present invention may further include a transceiver 330, an input interface 340, an output interface 350, a storage device 360, etc. Respective components included in the apparatus 300 for testing a battery by estimating state of health are connected by a bus 370 and can communicate with one another.

Additionally, the memory 320 (or storage device) may be configured to include at least one of a volatile storage medium and a non-volatile storage medium. For example, the memory may include at least one of read only memory (ROM) and random access memory (RAM), and may also include electrically erasable programmable read-only memory (EEPROM) .

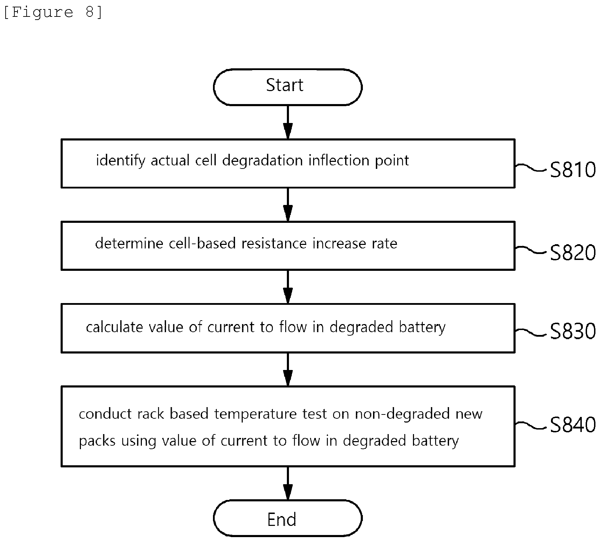

FIG. 8 shows an operational sequence of a method for testing a battery by estimating state of health according to embodiments of the present invention.

In the method for testing a battery by estimating state of health according to embodiments of the present invention, an actual cell degradation inflection point may be identified (S810) and a cell-based resistance increase rate may be determined (S820). Afterwards, a value of current to flow through a battery in a degraded state may be calculated using a relationship among internal resistance of the battery, current flowing through the battery, and amount of heat generation (S830).

Here, the relationship among the internal resistance of the battery, the current flowing through the battery, and the amount of heat generation may include equations 1 to 4 described earlier.

In other words, the value of current to flow in a battery of degraded state may be calculated based on the battery pack based resistance increase rate according to the cell based resistance increase rate, the amount of heat generated in a degraded batery pack, an internal resistance value of a non-degderaded new battery pack, and the internal resistance value of the degraded battery pack which is calculated according to the battery pack based resistance increase rate.

Afterwards, a degradation prediction test is performed in a simulated state of a degraded battery, which means that a rack based temperature test is performed on new packs that have not been degraded, using the value of current to flow in the batery of degraded state (S840).

The operations of the method according to the embodiments of the present invention may be implemented as a computer-readable program or code on a computer-readable recording medium. The computer-readable recording medium includes all types of recording devices in which data readable by a computer system is stored. In addition, the computer-readable recording medium may be distributed in a network-connected computer system to store and execute computer-readable programs or codes in a distributed manner.

In addition, the computer-readable recording medium may include hardware devices specially configured to store and execute program instructions, such as read-only memory (ROM), random access memory (RAM), flash memory, etc. The program instructions may include not only machine language code created by a compiler, but also high-level language code that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

## Claims

**1.** An apparatus for testing a battery rack including at least one battery pack by estimating state of health, the apparatus comprising:

at least one processor; and
a memory configured to store instructions executed by the at least one processor,
wherein the instructions, when executed, cause the processor to:

implement a degraded battery simulation state using a relationship among an internal resistance of the battery, a current flowing through the battery, and an amount of heat generated in a degraded batery pack; and
perform a degradation prediction test in the degraded battery simulation state.

**2.** The apparatus of claim 1, wherein the instructions, when executed, cause the processor to:

identify a measured cell degradation inflection point;
determine a cell-based resistance increase rate; and
calculate a value of current to flow in a batery having a degraded state using the relationship among the internal resistance of the battery, the current flowing through the battery, and the amount of heat generated in the degraded batery pack.

**3.** The apparatus of claim 2, wherein the instructions, when executed, cause the processor to:

calculate a battery pack-based resistance increase rate according to the cell-based resistance increase rate;
calculate an internal resistance value of the degraded battery pack according to the battery pack-based resistance increase rate; and
calculate the value of current to flow in the batery having the degraded state based on the amount of heat generated in the degraded batery pack, an internal resistance value of a non-degraded new battery pack, and the internal resistance value of the degraded battery pack.

**4.** The apparatus of claim 3, wherein the amount of heat generated in the degraded batery pack represented in the degraded battery simulation state is based on the measured cell degradation inflection point.

**5.** The apparatus of claim 1, wherein the instructions, when executed, cause the processor perform a rack-based temperature test on new battery packs that have not degraded, using the value of current to flow in the battery having the degraded state.

**6.** The apparatus of claim 5, wherein the instructions, when executed, cause the processor to apply the value of current to flow in the battery having the degraded state to the battery rack using a load connected to the battery rack including at least one non-degraded new battery pack.

**7.** A method for testing a battery rack including at least one battery pack by estimating state of health, the method comprising:

implementing a degraded battery simulation state using a relationship among an internal resistance of the battery, a current flowing through the battery, and an amount of heat generated in a degraded batery pack; and
performing a degradation prediction test in the degraded battery simulation state.

**8.** The method of claim 7, wherein implementing the degraded battery simulation state includes:

identifying a measured cell degradation inflection point;
determining a cell-based resistance increase rate; and
calculating a current value flowing in a batery having a degraded state using a relationship among the internal resistance of the battery, the current flowing through the battery, and the amount of heat generated in the degraded batery pack.

**9.** The method of claim 8, further comprising:

calculating a battery pack-based resistance increase rate according to the cell-based resistance increase rate; and
calculating an internal resistance value of the degraded battery pack according to the battery pack-based resistance increase rate;
wherein calculating the value of current to flow in the batery having the degraded state is based on the amount of heat generated in the degraded batery pack, an internal resistance value of a non-degraded new battery pack, and the internal resistance value of the degraded battery pack.

**10.** The method of claim 9, wherein the amount of heat generated in the degraded batery pack represented in the degraded battery simulation state is based on the measured cell degradation inflection point.

**11.** The method of claim 7, wherein performing the degradation prediction test includes performing a rack-based temperature test on new battery packs that have not degraded, using the value of current to flow in the battery having the degraded state.

**12.** The method of claim 11, wherein performing the rack based temperature test includes applying the value of current to flow in the battery having the degraded state to the battery rack using a load connected to the battery rack including at least one non-degraded new battery pack.

[Figure 1]

BBMS / BSC
Rack #1
Rack #2
Rack #3
Pack #1
Pack #1
Pack #1
Pack #2
Pack #2
Pack #2

[Figure 2]

Cell 1
Cell 2
Cell 3
Cell 4
Cycles
Capacity(Ah)
0
20
40
60
80
100
120
140
160
2.0
1.8
1.6
1.4
1.2

[Figure 3a]

10cycle
30cycle
60cycle
90cycle
120cycle
150cycle
160cycle
168cycle
Voltage(V)
Time(s)
4.2
4.0
3.8
3.6
3.4
3.2
0
100
200
300
400
500

[Figure 3b]

10cycle
30cycle
60cycle
90cycle
120cycle
150cycle
160cycle
168cycle
ΔV
Time(s)
Voltage(V)

[Figure 4]

Phase 1 (6 months)
Phase 2 (6 months)
Phase 3 (6 months)
1) identify actually measured degradation inflection point of cell, 2) determine cell-based resistance increase rate
degradation of real pack(usually lowering state of health by accelerated degradation, SOH: 100% -> 90%)
perform rack level temperature test using degraded pack

[Figure 5]

Phase 1 (6 months)
Phase 3 (6 months)
1) identify actually measured degradation inflection point of cell, 2) determine cell-based resistance increase rate
=> estimate state of health at 20 years of use through 1) and 2)
1) check rack based temperature increase and calculate pack based resistance increase rate based on cell test results
2) conduct rack based performance test using BOL pack
battery verification time shortened by 6 months or more

[Figure 6]

200
LOAD
+
-
100

[Figure 7]

300
310
processor
320
memory
ROM
RAM
330
transceiver
340
input interface
350
output interface
360
storage device
370

[Figure 8]

Start
identify actual cell degradation inflection point
S810
determine cell-based resistance increase rate
S820
calculate value of current to flow in degraded battery
S830
conduct rack based temperature test on non-degraded new packs using value of current to flow in degraded battery
S840
End

## INTERNATIONAL SEARCH REPORT

International application No. **PCT/KR2023/012366**

**A. CLASSIFICATION OF SUBJECT MATTER**

**G01R 31/392**(2019.01)i; **G01R 31/367**(2019.01)i; **G01R 31/3828**(2019.01)i; **G01R 19/165**(2006.01)i; **H01M 10/48**(2006.01)i

According to International Patent Classification (IPC) or to both national classification and IPC

**B. FIELDS SEARCHED**

Minimum documentation searched (classification system followed by classification symbols)

G01R 31/392(2019.01); B60L 11/18(2006.01); G01R 31/36(2006.01); G01R 31/367(2019.01); H02J 7/04(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 전지(battery), 저항(resistor), 전류(current), 모사(simulation), 예측(prediction), 퇴화(atrophy), 발열량(heating value)

**C. DOCUMENTS CONSIDERED TO BE RELEVANT**

| Category* | Citation of document, with indication, where appropriate, of the relevant passages | Relevant to claim No. |
|---|---|---|
| X<br>Y | KR 10-2021-0089021 A (LG ENERGY SOLUTION, LTD.) 15 July 2021 (2021-07-15)<br>See paragraphs [0024]-[0062] and claim 1. | 1,7<br>2-6,8-12 |
| Y | KR 10-0839385 B1 (SAMSUNG SDI CO., LTD.) 19 June 2008 (2008-06-19)<br>See claims 3-4. | 2-6,8-12 |
| A | KR 10-2022-0086831 A (SAMSUNG ELECTRONICS CO., LTD.) 24 June 2022 (2022-06-24)<br>See claims 1-7. | 1-12 |
| A | KR 10-2021-0028397 A (LG CHEM, LTD.) 12 March 2021 (2021-03-12)<br>See claims 1-5. | 1-12 |
| A | US 2015-0247902 A1 (MAXIM INTEGRATED PRODUCTS, INC.) 03 September 2015 (2015-09-03)<br>See entire document. | 1-12 |

☐ Further documents are listed in the continuation of Box C. ☑ See patent family annex.

* Special categories of cited documents:
"A" document defining the general state of the art which is not considered to be of particular relevance
"D" document cited by the applicant in the international application
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **11 December 2023** | **11 December 2023** |

| Name and mailing address of the ISA/KR | Authorized officer |
|---|---|
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
**Information on patent family members**

International application No.
**PCT/KR2023/012366**

| Patent document cited in search report | Publication date (day/month/year) | Patent family member(s) | Publication date (day/month/year) |
|---|---|---|---|
| KR 10-2021-0089021 A | 15 July 2021 | CN 114729971 A | 08 July 2022 |
| | | EP 4043897 A1 | 17 August 2022 |
| | | EP 4043897 A4 | 30 November 2022 |
| | | JP 2023-502622 A | 25 January 2023 |
| | | JP 7376189 B2 | 08 November 2023 |
| | | US 2023-0022353 A1 | 26 January 2023 |
| | | WO 2021-141255 A1 | 15 July 2021 |
| KR 10-0839385 B1 | 19 June 2008 | KR 10-2008-0039655 A | 07 May 2008 |
| | | US 2008-0103709 A1 | 01 May 2008 |
| | | US 7684942 B2 | 23 March 2010 |
| KR 10-2022-0086831 A | 24 June 2022 | CN 114646879 A | 21 June 2022 |
| | | EP 4016100 A1 | 22 June 2022 |
| | | US 2022-0200071 A1 | 23 June 2022 |
| KR 10-2021-0028397 A | 12 March 2021 | None | |
| US 2015-0247902 A1 | 03 September 2015 | CN 102565715 A | 11 July 2012 |
| | | CN 102565715 B | 12 April 2017 |
| | | DE 102011056137 A1 | 14 June 2012 |
| | | US 10139452 B2 | 27 November 2018 |
| | | US 2012-0139546 A1 | 07 June 2012 |
| | | US 2018-0038914 A1 | 08 February 2018 |
| | | US 9035616 B2 | 19 May 2015 |
| | | US 9791517 B2 | 17 October 2017 |

Form PCT/ISA/210 (patent family annex) (July 2022)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- KR 1020220175914